# EUROPEAN PATENT APPLICATION

(11) **EP 4 686 341 A1**
(43) Date of publication of application: **28.01.2026**
(21) Application number: 25176569.9
(22) Date of filing: 15.05.2025
(51) Int. Cl.: H10D 30/67

(54) **TRANSISTOR, DISPLAY DEVICE INCLUDING THE SAME, AND MANUFACTURING METHOD OF THE TRANSISTOR**

(30) Priority: 25.07.2024 KR 20240098563
(71) Applicant: Samsung Display Co., Ltd., Yongin-si Gyeonggi-do (KR); UIF (University Industry Foundation), Seodaemun-gu Seoul 03722 (KR)
(72) Inventor: LEE, Sun Hee, Yongin-si, Gyeonggi-do (KR); KIM, Hyun Jae, 03722 Seoul (KR); CHUNG, Jusung, 03722 Seoul (KR); CHOI, Hye Lim, Yongin-si, Gyeonggi-do (KR)
(74) Representative: Gulde & Partner

(57) **Abstract**

The present invention refers to a transistor, an electronic device including the same, and a manufacturing method thereof. The transistor includes: a gate electrode; a semiconductor layer overlapping the gate electrode and including an oxide semiconductor; a source electrode and a drain electrode overlapping a portion of the semiconductor layer, respectively. A channel region of the semiconductor layer is divided into a plurality of regions, each region extending between the source electrode and the drain electrode. The plurality of regions include a first region and a third region, and a second region disposed between the first region and the third region, and a number of M-O bonds in the first region and in the third region is smaller than a number of M-O bonds in the second region, wherein the M is a metal and the O is oxygen.

## Description

### 1. Technical Field

The present disclosure relates to a transistor, to an electronic device, for example, a display device, including the transistor, and a manufacturing method of the transistor.

### 2. Description of the Related Art

A display device generally includes a plurality of signal lines, a plurality of pixels, and a driving circuit (for example, a gate driver and a data driver) configured to control the pixels. Each pixel includes a display element and a pixel driving circuit that controls the display element. The pixel driving circuit may include a plurality of transistors electrically interconnected.

### SUMMARY

The invention is defined by the appended claims. The description that follows is subjected to this limitation. Any disclosure lying outside the scope of said claims is only intended for illustrative as well as comparative purposes.

Embodiments of the present disclosure provide a transistor with specific characteristics, a display device including the transistor, and a manufacturing method of the transistor.

An embodiment of the present disclosure provides a transistor including: a gate electrode; a semiconductor layer overlapping the gate electrode and including an oxide semiconductor; a source electrode and a drain electrode overlapping a portion of the semiconductor layer, respectively, wherein a channel region of the semiconductor layer is divided into a plurality of regions, each region extending between the source electrode and the drain electrode. The plurality of regions includes a first region and a third region, and a second region disposed between the first region and the third region, and a number of M-O bonds in the first region and in the third region is smaller than a number of M-O bonds in the second region, wherein the M is a metal and the O is oxygen.

An amount of oxygen vacancy (Vo) included in the first region and an amount of oxygen vacancy included in the second region are different.

The amount of oxygen vacancy included in the second region may be smaller than the amount of oxygen vacancy included in the first region.

An amount of -OH included in the first region and an amount of -OH included in the second region are different.

The amount of -OH included in the second region may be smaller than the amount of -OH included in the first region.

The oxide semiconductor may include zinc (Zn), indium (In), gallium (Ga), tin (Sn), or titanium (Ti).

An embodiment of the present disclosure provides an electronic device including: a display device including: a substrate; a first transistor disposed on the substrate, which is a transistor as mentioned above; and a light emitting element electrically connected to the first transistor.

The display device may further include a display area in which a plurality of pixels are disposed, and a non-display area adjacent to the display area, wherein the first transistor is disposed in the display area.

A gate driver and a data driver are disposed in the non-display area, at least one of the gate driver and the data driver may include a second transistor, and the second transistor has the same characteristics in its channel region.

A pixel may include a plurality of transistors, and at least one of the plurality of transistors is the first transistor.

A driving transistor of the plurality of transistors may be the first transistor.

An embodiment of the present disclosure provides a manufacturing method of a transistor including: forming an oxide semiconductor layer on a substrate; disposing a mask on the oxide semiconductor layer irradiating it with ultraviolet (UV) light; annealing the oxide semiconductor layer; and forming a gate electrode that overlaps a portion of the oxide semiconductor layer, a portion of a source electrode, and a portion of a drain electrode, wherein the annealing and the irradiating of the UV light are simultaneously performed. The mask (MASK) is configured in such a way that during the irradiation an area of the oxide semiconductor layer that forms the second region in the transistor is irradiated more intensely or exclusively compared to the areas of the oxide semiconductor layer that form the first region and the third region in the transistor.

The oxide semiconductor layer includes a first region and a third region that overlap the mask, and a second region disposed between the first region and the third region, and a first intensity of UV light irradiated onto the second region and a second intensity of UV light irradiated onto the first region and the third region may be different.

The first intensity may be greater than the second intensity.

The annealing may be performed at 250°C to 350°C for 45 minutes to 90 minutes.

The oxide semiconductor layer may have a first width, an opening of the mask has a second width, and the second width is 0.3 to 0.7 times the first width.

The oxide semiconductor layer includes an oxide semiconductor, and the oxide semiconductor may include zinc (Zn), indium (In), gallium (Ga), tin (Sn), or titanium (Ti).

An amount of oxygen vacancy included in the second region is smaller than an amount of oxygen vacancy included in the first region.

### BRIEF DESCRIPTION OF THE DRAWINGS

FIG. 1 is a cross-sectional view of a transistor according to an embodiment.
FIG. 2 is a schematic top plan view of a transistor according to an embodiment.
FIG. 3 is a schematic top plan view of a transistor according to an embodiment.
FIGS. 4, 5, 6 and 7 illustrate a manufacturing method of a transistor according to an embodiment.
FIG. 8 is a cross-sectional view of a display panel including a transistor according to an embodiment.
FIG. 9 is a top plan view of a display panel according to an embodiment.
FIG. 10 illustrates a circuit diagram of one pixel according to an embodiment.
FIGS. 11, 12, 13, 14 and 15 respectively illustrate a characteristic graph according to a comparative example and an example embodiment.
FIG. 16 and FIG. 17 respectively illustrate a characteristic graph according to a comparative example and an example embodiment.
FIGS. 18, 19 and 20 respectively illustrate a characteristic graph according to a comparative example and an example embodiment.
FIG. 21 is an electronic device in which embodiments of the present disclosure are implemented.

### DETAILED DESCRIPTION OF THE EMBODIMENTS

The present disclosure will be described in detail below with reference to the accompanying drawings, which illustrate embodiments of the disclosure.

To clearly present the disclosure, irrelevant parts or portions have been omitted, and identical or similar components throughout the specification are indicated by the same reference numerals.

In the drawings, the size and thickness of each element are arbitrarily illustrated for ease of description, and are not intended to limit the scope of the present disclosure. Additionally, the thicknesses of layers, films, panels, regions, areas, etc., may be exaggerated to enhance clarity and facilitate understanding.

It should be understood that when an element such as a layer, film, region, or substrate is referred to as being "on" another element, it can be directly on the other element or intervening elements may also be present. When an element is referred to as being "directly on" another element, there are no intervening elements present. In the specification, the terms "on" or "above" refer to being positioned on or beneath the referenced object and do not necessarily imply placement on the upper side of the object relative to the gravitational direction.

In addition, unless explicitly stated otherwise, the term "comprise" and its variations such as "comprises" or "comprising" should be understood to indicate the inclusion of the stated elements without excluding any other elements.

Further, throughout the specification, the phrase "in a plan view" or "on a plane" refers to observing a target portion from the top, and the phrase "in a cross-sectional view" or "on a cross-section" refers to observing a cross-section formed by vertically cutting through the target portion from the side.

The present disclosure focuses on a specialized transistor with a semiconductor layer featuring distinct regions to enhance electrical performance. The semiconductor layer is divided into a first region, a second region, and a third region, where the second region is located between the first and third. These regions are differentiated by their metal-oxygen (M-O) bond densities and oxygen vacancy levels, allowing for tailored electrical properties. This design enables a high sub-threshold swing (SS), improving the transistor's ability to regulate current flow, particularly for applications involving light-emitting components.

The present disclosure is particularly beneficial for display devices, where precise control over individual pixels is critical. The transistor's enhanced electrical characteristics allow for more efficient management of light-emitting elements in the display area. This technology facilitates better performance in OLED displays or other advanced display systems by integrating transistors with optimized regions, offering improved reliability and control. This approach provides a robust solution for enhancing display quality while maintaining manufacturing efficiency.

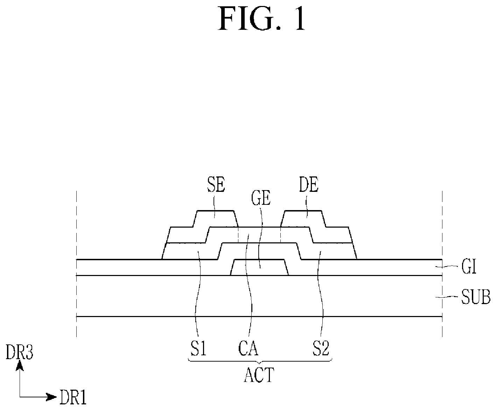

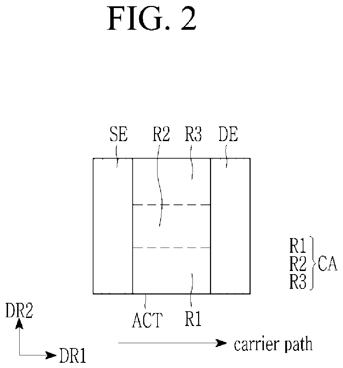

Hereinafter, a transistor according to an embodiment will be described with reference to FIG. 1 and FIG. 2. FIG. 1 illustrates a cross-sectional view of a transistor according to an embodiment, and FIG. 2 illustrates a schematic top plan view of a transistor according to an embodiment.

First, referring to FIG. 1, a transistor according to an embodiment may be disposed on a substrate SUB. The substrate SUB may include a flexible material such as plastic capable of being bent, curved, folded, or rolled, or it may be made of a rigid material.

The transistor according to the embodiment includes a gate electrode GE, a semiconductor layer ACT, a source electrode SE, and a drain electrode DE.

The gate electrode GE is disposed on the substrate SUB. For example, portions of the gate electrode GE may be in direct contact with the substrate SUB. The gate electrode GE may be a multifilm in which a metal film including one of copper (Cu), a copper alloy, aluminum (Al), an aluminum alloy, molybdenum (Mo), and a molybdenum alloy is stacked. In the present specification, a bottom gate structure in which the gate electrode GE is disposed under the semiconductor layer ACT is illustrated. However, the present disclosure is not limited thereto, and a top gate structure, where the gate electrode GE is positioned above the semiconductor layer ACT, is also possible.

A gate insulating film GI may be disposed on the substrate SUB and the gate electrode GE. The gate insulating film GI may be a single layer or multiple layers including at least one of silicon nitride (SiNₓ), silicon oxide (SiO₂), and silicon oxynitride.

The semiconductor layer ACT may be disposed on the gate insulating film GI. The semiconductor layer ACT includes an oxide semiconductor. The oxide semiconductor may be composed of a metal oxide such as zinc (Zn), indium (In), gallium (Ga), tin (Sn), and titanium (Ti), or a combination of metals such as zinc (Zn), indium (In), gallium (Ga), tin (Sn), titanium (Ti), and an oxide thereof. More specifically, the oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc oxide (IZTO), and the like.

The semiconductor layer ACT may include a first contact region S1, a channel region CA, and a second contact region S2. The channel region CA may be disposed between the first contact region S1 and the second contact region S2. The first contact region S1 may be electrically connected to the source electrode SE, and the second contact region S2 may be electrically connected to the drain electrode DE. The first contact region S1 and the second contact region S2 may be doped with dopants to achieve relatively higher conductivity than the channel region.

The source electrode SE and the drain electrode DE are disposed on the semiconductor layer ACT. Each of the source electrode SE and the drain electrode DE may be connected to the first contact region S1 and the second contact region S2 of the semiconductor layer ACT, respectively. In the present specification, an embodiment in which the source electrode SE and the drain electrode DE are directly disposed on the semiconductor layer ACT is illustrated. However, the present disclosure is not limited thereto, and a separate insulating film may be disposed between the source electrode SE and the semiconductor layer ACT, and between the drain electrode DE and the semiconductor layer ACT. In this case, the source electrode SE and the drain electrode DE may be respectively electrically connected to the first contact region S1 and the second contact region S2 of the semiconductor layer ACT through an opening formed in the insulating film.

Each of the source electrode SE and the drain electrode DE may be a multifilm in which a metal film including one of copper (Cu), a copper alloy, aluminum (Al), an aluminum alloy, molybdenum (Mo), and a molybdenum alloy is stacked.

Hereinafter, the semiconductor layer according to the embodiment will be described in more detail with reference to FIG. 2.

The channel region CA exposed by the source electrode SE and the drain electrode DE will be described with reference to FIG. 2. In the present specification, a direction in which the carrier moves is referred to as a first direction DR1, and a direction perpendicular to the first direction DR1 is referred to as a second direction DR2.

The semiconductor layer ACT is divided into a plurality of regions. Each region extends between the source electrode SE and the drain electrode DE. The plurality of regions includes a first region R1, a second region R2, and a third region R3 disposed along the second direction DR2. The second region R2 is disposed between the first region R1 and the third region R3.

The first region R1, the second region R2, and the third region R3 include an oxide semiconductor. The oxide semiconductor may include zinc oxide (ZnO), zinc-tin oxide (ZTO), zinc-indium oxide (ZIO), indium oxide (InO), titanium oxide (TiO), indium-gallium-zinc oxide (IGZO), indium-zinc oxide (IZTO), and the like.

The first region R1, the second region R2, and the third region R3 have different characteristics. The respective regions may exhibit different characteristics. For example, the first region R1 and the third region R3 may share the same characteristics, while the second region R2 may have different characteristics from the first region R1 and the third region R3.

The number of M-O bonds in the first region R1 is different from the number of M-O bonds in the second region R2. The number of M-O bonds in the first region R1 is smaller than the number of M-O bonds in the second region R2. In this case, the M represents a metal, such as zinc (Zn), indium (In), gallium (Ga), tin (Sn), and titanium (Ti). In other words, the M may include at least one of zinc (Zn), indium (In), gallium (Ga), tin (Sn), and titanium (Ti).

The number of M-O bonds in the third region R3 is different from the number of M-O bonds in the second region R2. The number of M-O bonds in the third region R3 is smaller than the number of M-O bonds in the second region R2.

The first region R1 and the third region R3 are formed using a heat treatment process, while the second region R2 is formed using both a heat treatment process and a UV light irradiation process. In the second region R2, where both the heat treatment process and the UV light irradiation process are performed, the M-O bonds may increase compared to the first region R1 and the third region R3 where only the heat treatment process is performed. The first region R1 and the third region R3 may include substantially the same amount of MO bonds.

In the first region R1 and the third region R3, the M-O bonds may be 50% to 70% of the total bonds, and in the second region R2, the M-O bonds may be more than 70% of the total bonds.

The amount of oxygen vacancy (%) in the first region R1 and the amount of oxygen vacancy (%) in the second region R2 may be different. In other words, the percentage of oxygen vacancies in the first region R1 and the second region R2 may differ. In some embodiments, the amount of oxygen vacancy in the first region R1 may be greater than the amount of oxygen vacancy in the second region R2. In other words, the percentage of oxygen vacancies in the second region R2 may be smaller than the percentage of oxygen vacancies in the first region R1.

The amount of oxygen vacancy (%) in the third region R3 and the amount of oxygen vacancy (%) in the second region R2 may be different. In other words, the percentage of oxygen vacancies in the third region R3 and the second region R2 may differ. In some embodiments, the amount of oxygen vacancy in the third region R3 may be greater than the amount of oxygen vacancy in the second region R2. In other words, the percentage of oxygen vacancies in the second region R2 may be smaller than the percentage of oxygen vacancies in the third region R3.

As noted above, the first region R1 and the third region R3 may be formed using a heat treatment process, and the second region R2 may be formed using both a heat treatment process and a UV light irradiation process. In the second region R2, where both processes are applied, the oxygen vacancy may be reduced compared to the first region R1 and the third region R3 where only the heat treatment process is performed. The first region R1 and the third region R3 may include substantially the same amount of oxygen vacancy. In other words, the first region R1 and the third region R3 may contain substantially the same percentage of oxygen vacancies.

The amount of oxygen vacancy in the first region R1 and the third region R3 may be 5% to 30% based on the total bonding, and the amount of oxygen vacancy in the second region R2 may be less than 25% based on the total bonding.

The amount of -OH included in the first region R1 and the amount of -OH included in the second region R2 may be different. In some embodiments, the amount of -OH in the first region R1 may be greater than the amount of -OH in the second region R2. In other words, the amount of -OH in the second region R2 may be smaller than the amount of -OH in the first region R1. In this disclosure, -OH refers to hydroxyl groups.

The amount of -OH included in the third region R3 and the amount of -OH included in the second region R2 may be different. In some embodiments, the amount of -OH in the third region R3 may be greater than the amount of -OH in the second region R2. In other words, the amount of -OH in the second region R2 may be smaller than the amount of -OH in the third region R3.

As noted above, the first region R1 and the third region R3 may be formed using a heat treatment process, and the second region R2 may be formed using both a heat treatment process and a UV light irradiation process. In the second region R2 where both processes are applied, the amount of -OH may increase compared to the first region R1 and the third region R3 where only the heat treatment process is performed.

In the first region R1 and the third region R3, the number of -OH bonds may be within 20% of the total number of bonds, and in the second region R2, the number of -OH bonds may be within 5% of the total number of bonds.

According to the above-described embodiment, the channel region CA of the semiconductor layer ACT includes a plurality of regions R1, R2, and R3 with differing characteristics along a direction perpendicular to the moving direction of the carrier. These regions R1, R2, and R3 may exhibit distinct electrical characteristics. The semiconductor layer ACT demonstrates a relatively high sub-threshold swing (SS), enabling efficient control of transistors and light emitting elements connected to them.

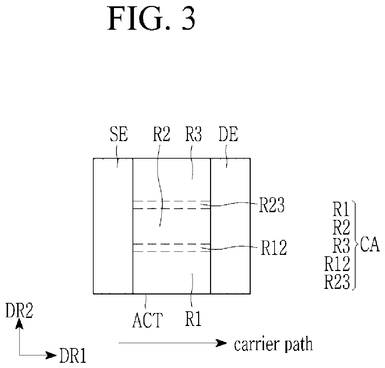

Hereinafter, a transistor according to another embodiment will be described with reference to FIG. 3. FIG. 3 illustrates a schematic top plan view of a transistor according to an embodiment. Descriptions of components identical to those previously described will be omitted.

Referring to FIG. 3, the channel region CA according to the embodiment includes a first region R1, a second region R2, and a third region R3. In addition, the channel region CA may include a first sub-region R12 disposed between the first region R1 and the second region R2, and a second sub-region R23 disposed between the second region R2 and the third region R3.

The embodiment in which the channel region CA is divided into three regions R1, R2, and R3 has been described above with reference to FIG. 2. The embodiment of FIG. 3 may include the first sub-region R12 disposed between the first region R1 and the second region R2 adjacent to each other as well as the second sub-region R23 disposed between the second region R2 and the third region R3 adjacent to each other. The first sub-region R12 may serve to gradually transition the physical properties between the first region R1 and the second region R2. The second sub-region R23 may provide a continuous transition in physical properties between the second region R2 and the third region R3.

As described above, the inclusion of the sub-regions R12 and R23 between the respective regions facilitates smooth changes in physical properties.

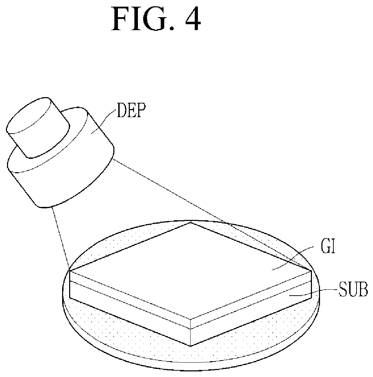

Hereinafter, a manufacturing method of a transistor according to an embodiment will be described with reference to FIG. 4 to FIG. 7. FIG. 4 to FIG. 7 illustrate a manufacturing method of a transistor according to an embodiment. Descriptions of components identical to those previously described will be omitted.

First, as shown in FIG. 4, an oxide semiconductor material is deposited on the substrate SUB and the insulating film GI using a deposition apparatus DEP.

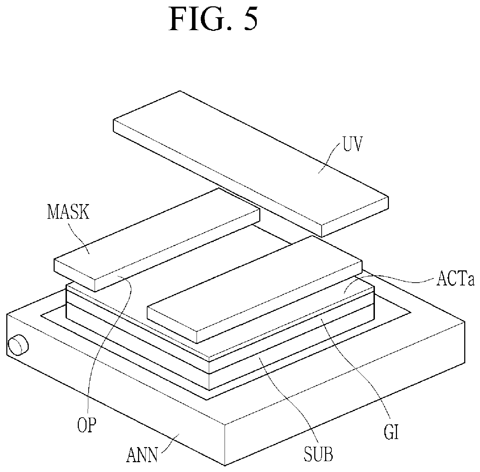

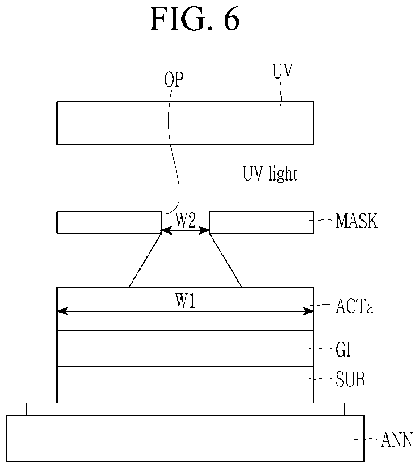

As shown in FIG. 5 and FIG. 6, a mask MASK is disposed on an oxide semiconductor layer ACTa. The mask MASK may cover areas designated for forming the first region and the third region, and may have an opening OP over the area designated for forming the second region. In this case, the opening OP may have a second width W2, and the oxide semiconductor layer ACTa may have a first width W1. A ratio of the second width W2 to the first width W1 may be 0.3 to 0.7, and for example, may be 0.5.

A UV lamp UV is positioned on the mask MASK. The UV lamp UV may irradiate UV light toward the oxide semiconductor layer ACTa. In this specification, an embodiment involving the irradiation of UV light is described; however, the disclosure is not limited to UV light, as embodiments involving the irradiation of visible light are also possible.

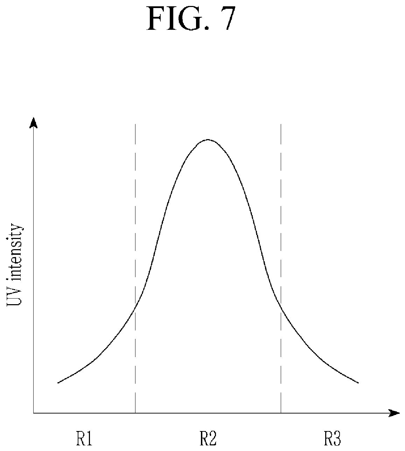

In this case, as shown in FIG. 7, the intensity of UV light irradiated onto the oxide semiconductor layer ACTa may be highest in the second region R2. In addition, UV light irradiation in the first region R1 and the third region R3 may be minimal or negligible, though some UV light may reach these regions due to diffraction effects.

Referring back to FIG. 5 and FIG. 6, an annealing process may be performed together with a UV light irradiation process. The substrate SUB may be disposed on an annealing device ANN. The UV light irradiation process and the annealing process may be simultaneously performed at 300°C for an hour. In this case, light in the wavelength bands of 185 nm and 254 nm may be irradiated at an intensity of 60 mW/cm².

After completing the above-described annealing process and UV light irradiation process, the semiconductor layers of FIG. 2 and FIG. 3 may be manufactured. As a result, the semiconductor layers include a plurality of regions with different characteristics. These regions may exhibit different electrical characteristics. Furthermore, the semiconductor layers feature a relatively high sub-threshold swing (SS), which enhances the control of transistors and the light-emitting elements connected to them.

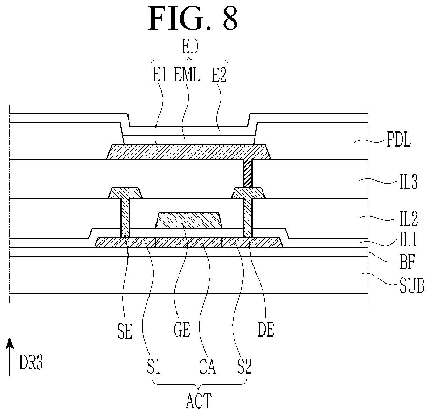

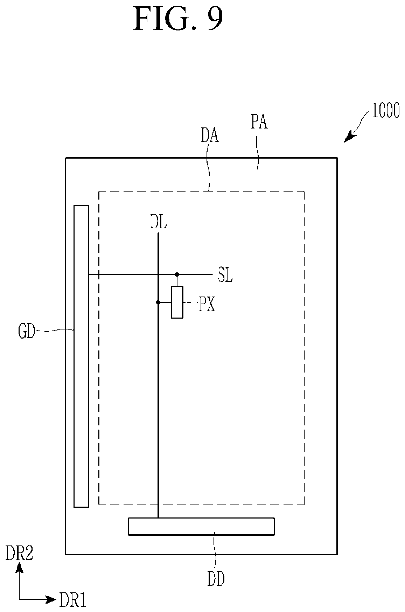

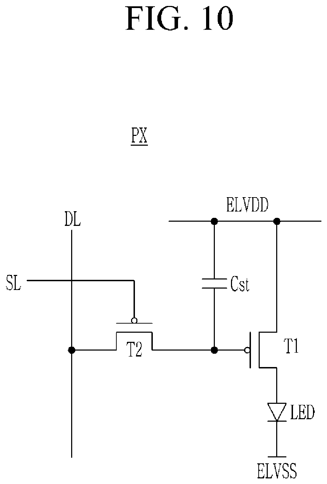

Hereinafter, a display device including the above-described transistors will be described with reference to FIG. 8 to FIG. 10. FIG. 8 illustrates a cross-sectional view of a display panel including a transistor according to an embodiment, FIG. 9 illustrates a top plan view of a display panel according to an embodiment, and FIG. 10 illustrates a circuit diagram of one pixel according to an embodiment.

Descriptions of components identical to those described above may be omitted.

First, referring to FIG. 8, a buffer layer BF may be disposed on the substrate SUB. The buffer layer BF may include silicon nitride (SiNₓ), silicon oxide (SiO₂), silicon oxynitride, or the like. The buffer layer BF may planarize the substrate SUB to relieve stress on the semiconductor layer ACT formed on the buffer layer BF.

The semiconductor layer ACT is disposed on the buffer layer BF. The semiconductor layer ACT may be made of an oxide semiconductor. The semiconductor layer ACT includes the channel region CA, the first contact region S1, and the second contact region S2. When the semiconductor layer ACT is made of an oxide semiconductor, a separate passivation layer may be added to protect an oxide semiconductor material that is vulnerable to external environments such as high temperature.

The semiconductor layer ACT according to the embodiment may be the semiconductor layer ACT described with reference to FIG. 2 or the semiconductor layer ACT described with reference to FIG. 3.

A gate insulating film IL1 is disposed on the semiconductor layer ACT. The gate insulating film IL1 may be a single layer or multiple layers including at least one of silicon nitride (SiNₓ), silicon oxide (SiO₂), and silicon oxynitride.

A gate electrode GE is disposed on the gate insulating film IL1, and the gate electrode GE may be a multifilm in which a metal film including one of copper (Cu), a copper alloy, aluminum (Al), an aluminum alloy, molybdenum (Mo), and a molybdenum alloy is stacked.

An interlayer insulating film IL2 is disposed on the gate electrode GE and the gate insulating film IL1. The interlayer insulating film IL2 may include silicon nitride (SiNₓ), silicon oxide (SiO₂), silicon oxynitride, or the like. An opening exposing the first contact region S1 and the second contact region S2, respectively, is disposed in the interlayer insulating film IL2.

The source electrode SE and the drain electrode DE are disposed on the interlayer insulating film IL2. The source electrode SE and the drain electrode DE are connected to the first contact region S1 and the second contact region S2 of the semiconductor layer ACT, respectively, through openings (or contact holes) formed in the interlayer insulating film IL2.

A passivation film IL3 is disposed on the interlayer insulating film IL2, the source electrode SE, and the drain electrode DE. The passivation film IL3 covers and planarizes the interlayer insulating film IL2, the source electrode SE, and the drain electrode DE, so that a first electrode E1 may be formed without a step on the passivation film IL3. The passivation film IL3 may be made of an organic material such as a polyacrylate resin and a polyimide resin, or a stacked film of organic and inorganic materials.

The first electrode E1 is disposed on the passivation film IL3. The first electrode E1 is electrically connected to the drain electrode DE through an opening of the passivation film IL3.

A driving transistor consisting of the gate electrode GE, the semiconductor layer ACT, the source electrode SE, and the drain electrode DE is connected to the first electrode E1 to supply a driving current to each light emitting element ED.

A partition wall PDL is disposed on the first electrode E1. The partition wall PDL includes an opening, and a light emitting layer EML may be disposed in the opening. A second electrode E2 may be disposed on the light emitting layer EML.

Here, the first electrode E1 may be an anode, which is a hole injection electrode, and the second electrode E2 may be a cathode, which is an electron injection electrode. However, the embodiment is not necessarily limited thereto, and the first electrode E1 may be a cathode and the second electrode E2 may be an anode, according to a driving method of the display device.

Next, referring to FIG. 9, a display device 1000 according to an embodiment may include a display area DA and a non-display area PA surrounding the display area DA.

The display area DA may contain a plurality of pixels PX disposed in a matrix form. Each pixel PX may be electrically connected to a plurality of signal lines. For example, the pixel PX may be electrically connected to a first signal line SL extending along the first direction DR1 and a second signal line DL extending along the second direction DR2. For example, the first signal line SL may be a scan line, and the second signal line DL may be a data line.

A plurality of first signal lines SL may extend to the non-display area PA to be electrically connected to a gate driver GD. A plurality of second signal lines DL may extend to the non-display area PA to be electrically connected to a data driver DD.

Each of the plurality of pixels PX may include the transistor described above with reference to FIG. 8. A first transistor disposed in the display area DA may include a transistor including a channel region divided into a plurality of regions as described in FIG. 8.

The gate driver GD and the data driver DD may include a second transistor. Unlike the transistor described in FIG. 8, the second transistor may have the same characteristics throughout the entire channel region. In other words, as in the embodiments of FIG. 2 and FIG. 3, the channel region may not be divided into a plurality of regions, but may include one region having one characteristic.

Next, referring to FIG. 10, one pixel PX may include a light emitting diode LED, a driving transistor T1, a capacitor Cst, and a switching transistor T2.

The driving transistor T1 includes a control electrode connected to the switching transistor T2, a first electrode for receiving a first light emitting power voltage ELVDD, and a second electrode connected to the light emitting diode LED. The capacitor Cst includes a first electrode for receiving the first light emitting power voltage ELVDD and a second electrode connected to the control electrode of the driving transistor T1. The switching transistor T2 includes a control electrode electrically connected to the scan line SL to receive a scan signal, a first electrode electrically connected to the data line DL to receive a data signal, and a second electrode connected to the control electrode of the driving transistor T1. The light emitting diode LED includes an anode electrode connected to the driving transistor T1 and a cathode electrode for receiving a second light emitting power voltage ELVSS. When the switching transistor T2 is turned on, the current flowing through the driving transistor T1 is applied to the light emitting diode LED, and the light emitting diode LED emits light.

As such, one pixel may include a plurality of transistors. In this case, at least one transistor may be a transistor including the semiconductor layer described with reference to FIG. 2 and FIG. 3. Specifically, the driving transistor T1 may be a transistor including the oxide semiconductor layer described with reference to FIG. 2 and FIG. 3.

In some embodiments, the switching transistor T2 may have the same characteristics throughout the entire channel region, unlike the transistor described in FIG. 8. In other words, as in the embodiments of FIG. 2 and FIG. 3, the channel region may not be divided into a plurality of regions R1, R2, and R3, but may include one region having one characteristic.

As illustrated in the embodiments of FIG. 9 and FIG. 10, it is possible to apply the semiconductor layer from FIG. 2 or FIG. 3 exclusively to a specific transistor among a plurality of transistors.

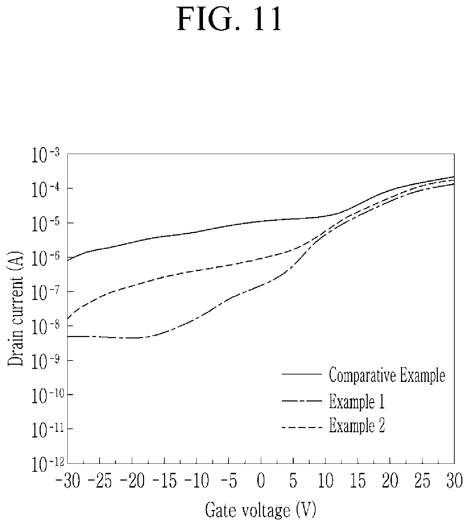

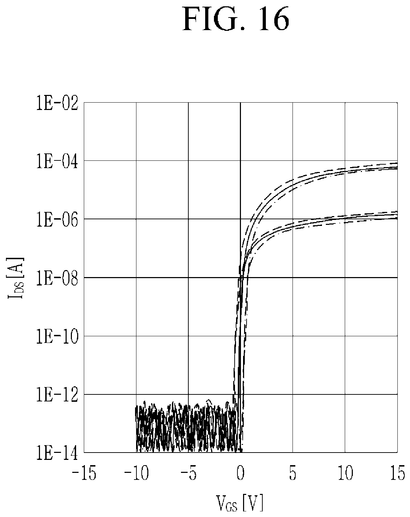

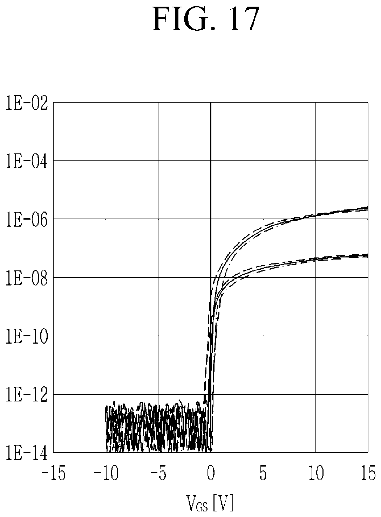

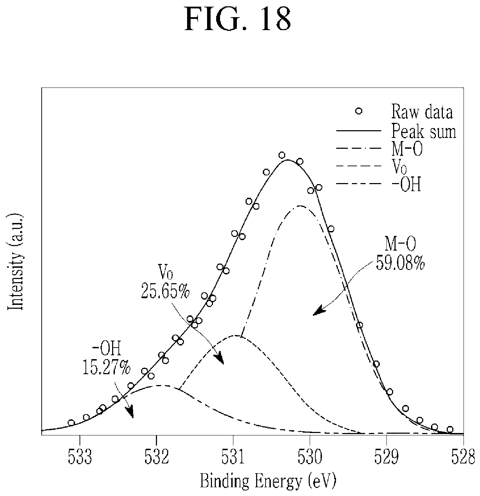

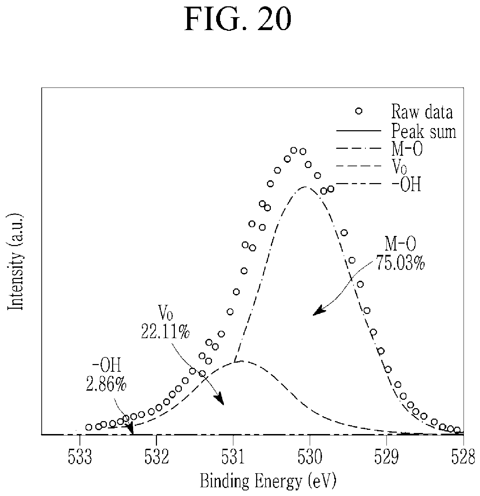

Hereinafter, characteristics of example embodiments and comparative examples will be described with reference to FIG. 11 to FIG. 20. FIG. 11 to FIG. 15 respectively illustrate a characteristic graph according to a comparative example and an example embodiment, FIG. 16 and FIG. 17 respectively illustrate a characteristic graph according to a comparative example and an example embodiment, and FIG. 18 and FIG. 20 respectively illustrate a characteristic graph according to a comparative example and an example embodiment.

In FIG. 11, FIG. 12, and FIG. 13, the comparative examples are a case where only a heat treatment process is performed on an oxide semiconductor layer, Example 1 is a case where both a UV light irradiation process and a heat treatment process are performed on an oxide semiconductor layer to be prepared as in the embodiment of FIG. 2, and Example 2 is a case where both a UV light irradiation process and a heat treatment process are performed on an oxide semiconductor layer to be prepared as in the embodiment of FIG. 3.

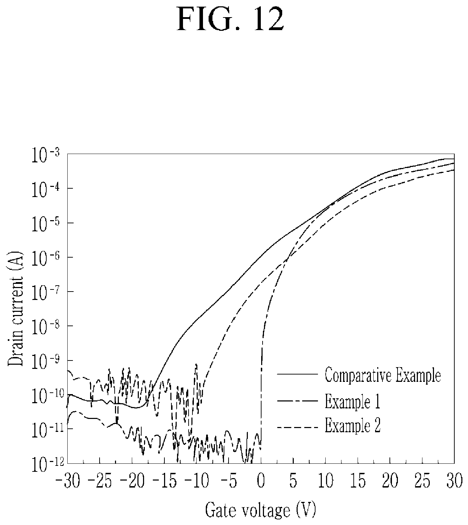

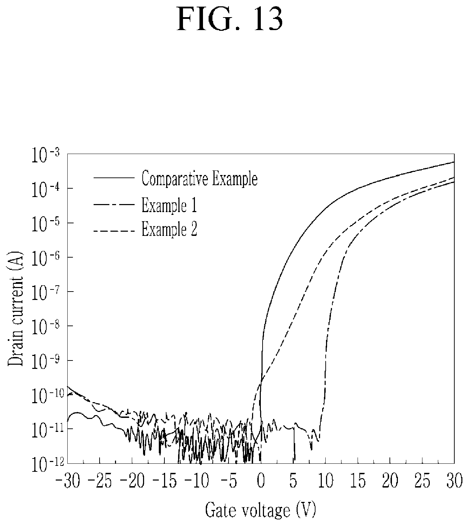

FIG. 11 illustrates a case where a heat treatment process is performed at 100°C, FIG. 12 illustrates a case where a heat treatment process is performed at 200°C, and FIG. 13 illustrates a case where a heat treatment process is performed at 300°C.

Referring to each comparative example, Example 1, and Example 2, it can be seen that the electrical characteristics are the best when the heat treatment process is performed at 300°C.

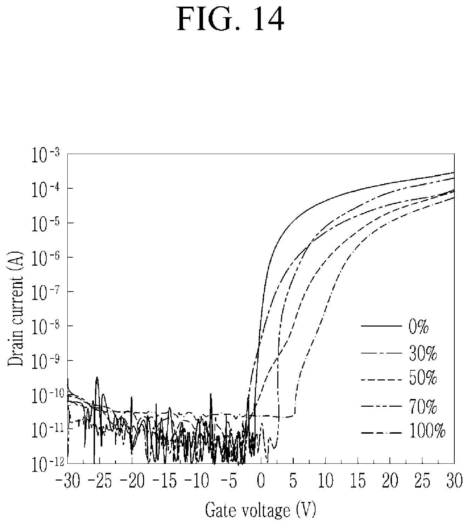

FIG. 14 is a graph illustrating how the characteristics change based on the percentage of the second width of the mask opening relative to the first width of the semiconductor layer. As shown in Fig. 14, it was observed that the highest sub-threshold swing (SS) value occurred when the percentage of the second width to the first width was 50%.

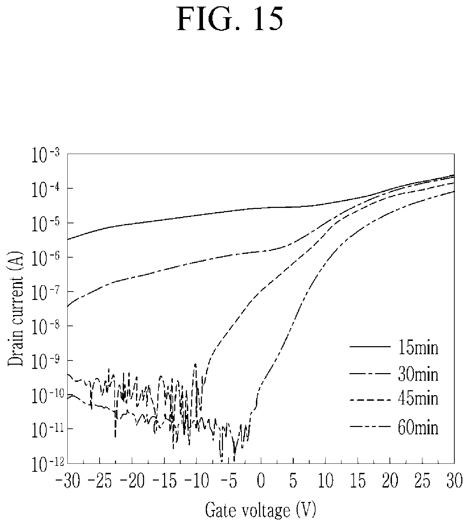

Next, referring to FIG. 15, the graph illustrates a change in electrical characteristics based on the duration of the heat treatment process. As illustrated in FIG. 15, it was determined that the best electrical characteristics were obtained when the heat treatment process was performed for about 60 minutes.

FIG. 16 is a characteristic graph of a comparative example in which the UV light irradiation process is not performed, and FIG. 17 is a characteristic graph of an example in which the UV light irradiation process is performed.

In a device in which all components are the same except for the UV light irradiation process, the slope of the graph in FIG. 17 may be smaller than the slope of the graph in FIG. 16. In other words, according to the embodiments, controlling the current flowing through the light-emitting element may be easier compared to the comparative example.

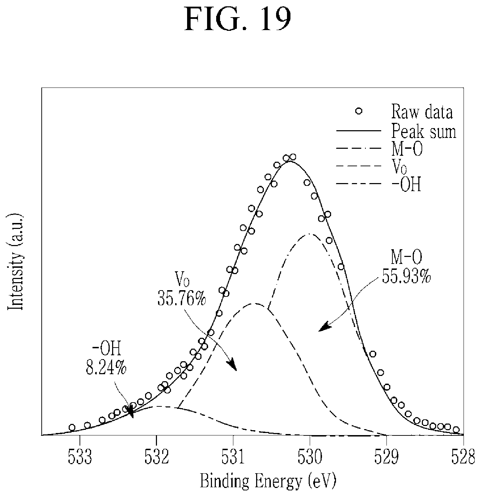

Next, FIG. 18 is a characteristic graph of a comparative example in which only the heat treatment process is performed according to a comparative example. FIG. 19 is a characteristic graph of a comparative example in which only the UV light irradiation process is performed according to the comparative example. FIG. 20 is a characteristic graph of an example in which both the UV light irradiation and the heat treatment processes are performed according to the example embodiment.

In FIG. 18 and FIG. 19, the amount of -OH was 15.27% and 8.24%, respectively, and in the example of FIG. 20, the amount of -OH was 2.86%, which was quite small. In addition, in the comparative examples of FIG. 18 and FIG. 19, the oxygen vacancies (%) were 25.65% and 35.76%, and in the example of FIG. 20, the oxygen vacancy was the lowest at 22.11%. In the comparative examples of FIG. 18 and FIG. 19, the M-O bonds were 59.08% and 55.93%, and in the example of FIG. 20, the M-O bond was the largest amount at 75.03%.

In other words, it was confirmed that differences existed in the M-O bonds, the amount of -OH groups, and the vacancy levels between the area subjected to both the heat treatment process and the UV light irradiation process and the area subjected to only the heat treatment process. These differences were found to correlate with variations in electrical characteristics.

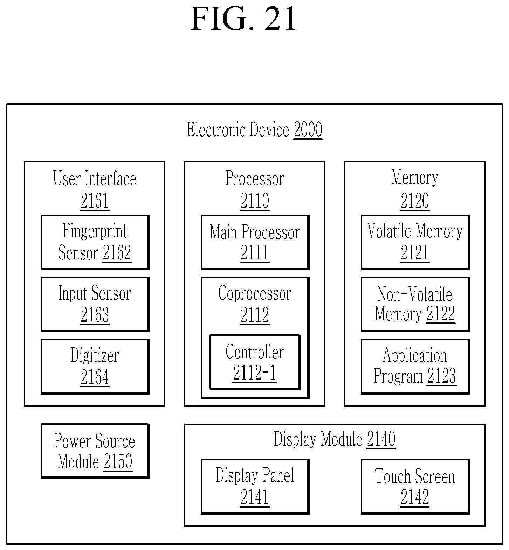

FIG. 21 is a diagram illustrating an electronic device according to an embodiment of the present invention. Referring to FIG. 21, the electronic device 2000 according to one embodiment of the present invention may output various information (e.g., images, text, music, etc.) through a display module 2140, which, for example, may correspond to the display panel shown in FIGS. 8 and 9. When a processor 2110 executes an application stored in a memory 2120, the display module 2140 may provide application information to a user through a display panel 2141.

In some embodiments, the electronic device 2000 may be configured as a smartphone, camera, smart TV, monitor, smartwatch, tablet, automotive display, or AR/VR headset. For example, the electronic device 2000 may be a smartphone including a touch-sensitive display area DA for interaction and a non-display area NDA including sensors and circuits for enhanced functionality. For example, the electronic device 2000 may be a television or monitor including a large display area DA for high-resolution video playback and a non-display area NDA incorporating driving circuits or connectivity modules for external inputs. For example, the electronic device 2000 may be a smartwatch including a display area DA optimized for compact and high-clarity visuals and a non-display area NDA integrating biometric sensors for health monitoring. In some cases, the electronic device 2000 be an AR/VR headset.

In some embodiments, memory 2120 may store information such as software codes for operating an application program 2123. The application program 2123 may include a software designed to execute specific tasks or provide functionality to a user. The application program 2123 may operate under the control of the processor 2110 and utilizes data stored in the memory 2120 to deliver a wide range of features, such as productivity tools, multimedia streaming and playback, file or mail deliveries or communication services. The application program 2123 interacts seamlessly with the user interface 2161 or touch screen 2142, allowing a user to launch, navigate, and utilize the program through user inputs such as touch, tap, gesture, or voice interaction.

Upon user selection of an application via touch screen 2142 or user interface 2161, the processor 2110 may execute the application program 2123 corresponding to the selected application retrieved from the memory 2120 to perform functionalities of the application. For example, when a user selects a camera application by tapping the icon (or a camera application icon) presented on the display panel 2141, the processor 2110 activates a camera module. The processor 2110 may transmit image data corresponding to a captured image acquired through the camera module to the display module 2140. The display module 2140 may display an image corresponding to the captured image through the display panel 2141.

As another example, when a user wishes to make a phone call, the user taps the telephone icon displayed on the display module 2140, the processor 2110 may execute a phone application program stored in the memory 2120. A telephone keypad may be presented on the display panel 2141 for the user to enter a phone number to call.

As another example, the display module 2140 may be integrated into an electronic device 2000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 2110 may include a main processor 2111 and an auxiliary or coprocessor 2112. The main processor 2111 may include a central processing unit (CPU). The main processor 2111 may further include one or more of a graphics processing unit (GPU), a communication processor (CP), and an image signal processor (ISP).

The coprocessor 2112 may include a controller 2112-1. The controller 2112-1 may include an interface conversion circuit and a timing control circuit. The controller 2112-1 may receive an image signal from the main processor 2111, convert the data format of the image signal to match the interface specifications with the display module 2140, and output image data. The controller 2112-1 may output various control signals to drive the display module 2140. For example, the controller 2112-1 may drive the display module 2140 to display the icon on the display screen suitable for selection by a user to cause execution of an application program 2123.

The memory 2120 may store one or more application programs 2123 and various data used by at least one component (for example, the processor 2110 or the user interface 2161) of the electronic device 2000 and input data or output data for commands related thereto. For example, a camera application program, a GPS application program, an augmented reality and virtual reality application program, and other application programs that can be executed by the processor 2110 upon selection of corresponding icons presented on the display screen (or display panel 2141) via the touch screen 2142 or user interface 2161 by the user. In addition, various setting data corresponding to user settings may be stored in the memory 2120. The memory 2120 may include volatile memory 2121 and nonvolatile memory 2122.

The display module 2140 may output visual information (images) to the user. The display module 2140 may include the display panel 2141, a gate driver, the source driver, a voltage generation circuit, and a touch screen 2142. The display module 2140 may further include a window, a chassis, and a bracket to protect the display panel 2141. The display module 2140 may include at least a part of the configuration of the display panel shown in FIGS. 8 and 9.

The user interface 2161 serves as the interaction medium between a user and the electronic device 2000. The user interface 2161 may detect an input by a part (e.g., finger) of a user's body or an input by a pen or a mouse, and generate an electric signal or data value corresponding to the input. The user interface 2161 includes the fingerprint sensor 2162, the input sensor 2163, and a digitizer 2164.

The fingerprint sensor 2162 may sense a fingerprint for biometric recognition of the user and may also measure one or more biological signals such as blood pressure, moisture, or body mass.

The input sensor 2163 may sense user interactions including touch, tap, gesture, motion, spoken command, and eye movement. The input sensor 2163 includes optical sensors for image capture, eye tracking, or motion and gesture detection. Optical sensors may be infrared or semiconductor photodetectors. The input sensor 2163 includes audio and acoustic sensors, which may be MEMS microphones for voice recognition or sound-based interaction. The audio and acoustic sensors can be installed as part of the user interface 2161 or embedded in the display panel 2141.

The digitizer 2164 may generate a data value corresponding to coordinate information of input by a pen or a mouse to control movement of an onscreen cursor. The digitizer 2164 may generate the amount of change in electromagnetic due to the input as the data value. The digitizer may detect an input by a passive pen or transmit and receive data with an active pen or a remote.

At least one of the fingerprint sensor 2162, the input sensor 2163, or the digitizer 2164 may be implemented as a sensor layer formed on the top layer of the display panel 2141 through a continuous process with a process of forming elements (for example, the light emitting element, the transistor, and the like) included in the display panel 2141.

In addition, the user interface 2161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 2142 includes touch sensors embedded in semiconductor layers of the display panel 2141 to sense pressure applied to the top layer (screen) of the display panel 2141. The touch sensors can be a capacitive or a resistive type. The touch screen 2142 may serve as the primary interface for the user to select and navigate applications, control, and interact with the electronic device 2000.

The display panel 2141 (or display) may include a liquid crystal display panel, an organic light emitting display panel, or an inorganic light emitting display panel, and the type of the display panel 2141 is not particularly limited. The display panel 2141 may be of a rigid type or a flexible type that can be rolled or folded. The display module 2140 may further include a supporter, bracket, heat dissipation member, and the like that support the display panel 2141. The display panel 2141 may include the display panel shown in FIGS. 8 and 9.

The power source module 2150 may supply power to the components of the electronic device 2000. The power source module 2150 may include a battery that charges the power source voltage. The battery may include a non-rechargeable primary battery or a rechargeable secondary battery or fuel cell. The power source module 2150 may include a power management integrated circuit (PMIC). The PMIC may supply optimized power source to each of the components described above including the display module 2140.

Although the embodiments of the present disclosure have been described with reference to practical examples, it should be understood that the disclosure is not limited to these specific embodiments.

## Claims

1. A transistor comprising:
a gate electrode (GE);
a semiconductor layer (ACT) overlapping the gate electrode (GE) and including an oxide semiconductor;
a source electrode (SE) and a drain electrode (DE) overlapping a portion of the semiconductor layer (ACT), respectively,
wherein a channel region (CA) of the semiconductor layer (ACT) is divided into a plurality of regions, each region extending between the source electrode (SE) and the drain electrode (DE), the plurality of regions including
a first region (R1) and a third region (R3), and
a second region (R2) disposed between the first region (R1) and the third region (R3),
wherein a number of M-O bonds in the first region (R1) and in the third region (R3) is smaller than a number of M-O bonds in the second region (R2), wherein the M is a metal and the O is oxygen.

2. The transistor of claim 1, wherein
an amount of oxygen vacancy included in the second region (R2) is smaller than an amount of oxygen vacancy included in the first region (R1) and in the third region (R3).

3. The transistor of claim 1 or 2, wherein
an amount of -OH included in the second region (R2) is smaller than an amount of -OH included in the first region (R1) and in the third region (R3).

4. The transistor of any one of the preceding claims, wherein the oxide semiconductor includes zinc (Zn), indium (In), gallium (Ga), tin (Sn), or titanium (Ti).

5. An electronic device comprising:
a display device (1000) comprising:
a substrate (SUB);
a first transistor, which is a transistor as claimed in any one of the preceding claims disposed on the substrate (SUB).

6. The electronic device of claim 5, wherein the display device (1000) further comprises
a display area (DA) in which a plurality of pixels (PX) are disposed, and
a non-display area (PA) adjacent to the display area (DA),
wherein the first transistor is disposed in the display area (DA).

7. The electronic device of claim 6, wherein
a gate driver (GD) and a data driver (DD) are disposed in the non-display area (PA),
at least one of the gate driver (GD) and the data driver (DD) includes a second transistor, and
the second transistor has the same characteristics in its channel region (CA).

8. The electronic device of claim 6 or 7, wherein
a pixel (PX) includes a plurality of transistors, and
at least one of the plurality of transistors is the first transistor.

9. The electronic device of claim 8, wherein
a driving transistor (T1) of the plurality of transistors is the first transistor.

10. A manufacturing method of a transistor as claimed in any one of claims 1 to 5, the method comprising the steps of:
forming an oxide semiconductor layer (ACTa) on a substrate (SUB);
disposing a mask (MASK) on the oxide semiconductor layer (ACTa) irradiating it with ultraviolet (UV) light, wherein the mask (MASK) is configured in such a way that during the irradiation an area of the oxide semiconductor layer (ACTa) that forms the second region (R2) in the transistor is irradiated more intensely or exclusively compared to the areas of the oxide semiconductor layer (ACTa) that form the first region (R1) and the third region (R3) in the transistor;
annealing the oxide semiconductor layer (ACTa); and
forming a gate electrode (GE) that overlaps a portion of the oxide semiconductor layer (ACTa), a portion of a source electrode (SE), and a portion of a drain electrode (DE),
wherein the annealing and the irradiating of the UV light are simultaneously performed to form a semiconductor layer (ACT) of the transistor.

11. The manufacturing method of the transistor of claim 10, wherein:
the oxide semiconductor layer (ACTa) includes
a first region (R1) and a third region (R3) that overlap the mask, and
a second region disposed between the first region and the third region, and
a first intensity of UV light irradiated onto the second region and a second intensity of UV light irradiated onto the first region and the third region are different,
wherein the first intensity is greater than the second intensity.

12. The manufacturing method of the transistor of claim 10 or 11, wherein the annealing is performed at 250 °C to 350 °C for 45 minutes to 90 minutes.

13. The manufacturing method of the transistor as claimed in any one of claims 10 to 12, wherein oxide semiconductor layer (ACTa) has a first width, an opening of the mask (MASK) has a second width, and the second width is 0.3 to 0.7 times the first width.
